# FASCICULE DE BREVET EUROPEEN

(11) **EP 3 024 640 B1**
(45) Date de publication et mention de la délivrance du brevet: **02.09.2020**
(21) Numéro de dépôt: 14755866.2
(22) Date de dépôt: 21.07.2014
(51) Int. Cl.: B29C 70/54, B29C 70/88, C23C 2/02, C23C 2/12, C23C 2/40, H01L 23/373, B32B 5/02, B32B 3/26, B32B 3/30

(54) **PIECE EN MATERIAU COMPOSITE AVEC PORTION DE CONDUCTIVITE THERMIQUE ET ELECTRIQUE ET PROCEDE DE FABRICATION D'UNE TELLE PIECE**
KOMPONENTE AUS EINEM VERBUNDSTOFF, MIT THERMISCH UND ELEKTRISCH LEITENDEM TEIL SOWIE VERFAHREN ZUR HERSTELLUNG SOLCH EINER KOMPONENTE
PART MADE FROM A COMPOSITE MATERIAL, COMPRISING A THERMALLY AND ELECTRICALLY CONDUCTIVE PORTION, AND METHOD FOR PRODUCING SUCH A PART

(30) Priorité: 23.07.2013 FR 1357239
(43) Date de publication de la demande: 01.06.2016
(73) Titulaire: SAFRAN, 75015 Paris (FR)
(72) Inventeur: MAISONNAVE, Nicolas, F-75014 Paris (FR); COLOT, Marc-Antoine, F-77300 Fontainebleau (FR); LEFRANCOIS, Julien, F-91700 Sainte Genevieve des Bois (FR)
(74) Mandataire: Cabinet Beau de Loménie
(86) Numéro de dépôt international: PCT/FR2014/051878
(87) Numéro de publication internationale: WO 2015/011391

(56) Documents cités:
- EP-A2- 2 602 097
- WO-A1-02/19346

## Description

### Arrière-plan de l'invention

La présente invention concerne les pièces réalisées en matériau composite à matrice organique notamment utilisées dans des aéronefs.

Dans le cadre des programmes de développement d'avions plus électriques, il est prévu de remplacer les actionneurs initialement pneumatiques ou hydrauliques par des actionneurs électriques utilisant des modules d'électroniques de puissance pour leur commande. Une gestion thermique performante de ces modules de puissance doit cependant être mise en œuvre afin de respecter les critères de performance, masse et volume définis pour ces systèmes.

Cette gestion thermique demande une utilisation optimisée des sources froides présentes à proximité des équipements d'électronique de puissance, comme en particulier les flux froids issus de l'air extérieur en contact avec les parois environnantes.

Les solutions actuellement disponibles pour refroidir les modules d'électroniques de puissance sont des échangeurs de chaleurs (caloduc, plaque froide, etc.), des ventilateurs, des dissipateurs métalliques, etc.

Les boîtiers renfermant des modules de commande sont réalisés en aluminium. Cependant, la technologie de ces boîtiers ne permet plus d'évacuer les calories générées par les composants ou circuits de puissance dont la densité pour un volume donné n'a cessé d'augmenter depuis ces trente dernières années. Afin d'évacuer la chaleur générée dans ces boîtiers qui est toujours plus importante, il est nécessaire de multiplier les dispositifs de refroidissement associés, ce qui accroît l'encombrement, la masse et le coût des systèmes de commande électriques.

Les matériaux composites, et en particulier les matériaux composites constitués d'un renfort en fibres de carbone consolidé par une matrice organique, représentent une bonne alternative à la technologie aluminium car ils sont légers, résistants et utilisent des fibres de carbone dont certaines variétés peuvent être de très bons conducteurs thermique et électrique.

Toutefois, comme expliqué en détails ci-après, la résine utilisée pour former la matrice agit comme un isolant autour des fibres empêchant une bonne conductivité thermique et électrique dans le matériau, ce qui est préjudiciable à l'évacuation de la chaleur. Aussi, il est nécessaire de pouvoir disposer de pièces en matériau composite à renfort en fibres de carbone densifié par une matrice de résine qui présentent néanmoins une bonne conductivité thermique et électrique.

Le document EP 2 602 097 divulgue un assemblage entre deux panneaux en matériau composite. Le document WO 02/19346 divulgue une méthode pour mettre à nu des fibres dans une pièce en matériau composite.

### Objet et résumé de l'invention

A cet effet, selon l'invention, il est proposé une pièce en matériau composite comprenant un renfort en fils ou fibres de carbone consolidé par une matrice organique (à base de résine), caractérisée en ce qu'elle comprend une ou plusieurs portions de conductivité thermique dans lesquelles les fibres ou fils de carbone sont au moins partiellement dépourvus de matrice, en ce que les parties des fibres ou fils de carbone dépourvus de matrice sont en contact avec un matériau thermiquement conducteur, et en ce que le matériau thermiquement conducteur est présent dans les porosités présentes entre les fibres ou fils de carbone dépourvus de matrice.

La substitution de la matrice par un matériau thermiquement conducteur dans une ou plusieurs portions déterminées dans le matériau composite de la pièce permet de créer des ponts thermiques entre les fibres ou fils de carbone du renfort et d'améliorer ainsi la conductivité thermique de la pièce. La pièce présente ainsi des capacités d'échange thermique améliorées qui permettent notamment d'optimiser la dissipation de la chaleur générée par des équipements ou composants en contact avec la pièce. L'amélioration de la conductivité thermique permet d'envisager de nouvelles architectures ou designs pour des applications jusqu'ici réservées à des pièces en matériau conducteur tel que du métal. Grâce à l'invention, ces mêmes pièces peuvent être maintenant réalisées en matériau composite, c'est-à-dire avec un gain de masse significatif par rapport aux pièces en matériau métallique.

Selon un premier aspect de la pièce de l'invention, celle-ci comporte sur sa surface une ou plusieurs portions de conductivité thermique. On améliore ainsi la conductivité thermique de la pièce en surface sans modifier significativement les propriétés mécaniques initiales de la pièce.

Selon un deuxième aspect de la pièce de l'invention, celle-ci comprend au moins un évidement, chaque évidement comportant une portion de conductivité thermique, ce qui permet de créer des ponts thermiques entre les fibres ou les fils carbone présents en profondeur dans la pièce et d'améliorer ainsi la conductivité thermique dans la pièce.

Selon un troisième aspect de la pièce de l'invention, le matériau thermiquement conducteur est en outre électriquement conducteur. La substitution de la matrice par un matériau en outre électriquement conducteur dans une ou plusieurs portions déterminées dans le matériau composite de la pièce permet de créer des contacts électriques entre les fibres ou fils de carbone du renfort et d'améliorer ainsi la conductivité électrique de la pièce.

Selon une application particulière de l'invention, la pièce constitue une paroi conductrice en matériau composite à matrice organique. La pièce peut également constituer un boîtier pour un équipement d'électronique de puissance. La pièce selon l'invention peut être avantageusement utilisée pour conditionner de l'électronique de puissance car la conductivité thermique améliorée de la pièce de l'invention permet de réaliser une gestion thermique efficace, par exemple dans le cas de la dissipation de la chaleur générée par des modules de commandes d'actionneurs électriques.

L'invention concerne également un aéronef comprenant au moins une pièce correspondant notamment à une paroi conductrice ou à un boîtier comme défini ci-avant.

L'invention concerne encore un procédé de réalisation d'une ou plusieurs portions de conductivité thermique dans une pièce en matériau composite comprenant un renfort en fibres ou fils de carbone consolidé par une matrice organique (à base de résine), le procédé étant caractérisé en ce qu'il comprend les étapes suivantes :
- élimination au moins partielle de la matrice dans une ou plusieurs portions de la pièce de manière à exposer au moins en partie des fibres ou fils de carbone,
- dépôt d'un matériau thermiquement conducteur sur les parties des fibres ou fils exposées.

Selon un premier aspect du procédé de l'invention, celui-ci comprend en outre une étape de formation d'au moins un évidement dans la pièce, l'étape d'élimination au moins partielle de la matrice organique étant réalisée dans l'évidement, ledit évidement étant comblé lors de l'étape de dépôt du matériau thermiquement conducteur sur les parties des fibres ou fils exposées.

Selon un deuxième aspect du procédé de l'invention, le renfort est réalisé par tissage entre une pluralité de fils de chaîne et une pluralité de fils de trame et, lors de la réalisation du renfort, on forme au moins une portion de déliaison s'étendant sur une surface et une profondeur déterminées, les fils flottés présents dans chaque portion de déliaison étant découpés après la réalisation du renfort de manière à former un évidement.

Selon un troisième aspect du procédé de l'invention, le matériau thermiquement conducteur est en outre électriquement conducteur.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels :
- les figures 1, 1A, 2, 2A, 3 et 3A sont des vues schématiques alternativement en perspective et en coupe montrant la réalisation d'une portion de conductivité thermique et électrique dans une pièce en matériau composite conformément à un mode de réalisation de l'invention,
- les figures 4, 4A, 5 et 5A sont des vues schématiques alternativement en perspective et en coupe montrant la réalisation d'une portion de conductivité thermique et électrique dans une pièce en matériau composite conformément à un autre mode de réalisation de l'invention,
- les figures 6 et 6A à 6E sont respectivement une vue schématique en perspective et des vues schématiques en coupe montrant la réalisation d'une portion de conductivité thermique et électrique dans une pièce en matériau composite conformément à encore un autre mode de réalisation de l'invention,
- les figures 7A, 7B, 8A, 8B, 9A, 9B, 10A et 10B sont des vues schématiques en coupe montrant la réalisation de différentes portions de conductivité thermique et électrique.

### Description détaillée de modes de réalisation

L'invention s'applique d'une manière générale à toute pièce en matériau composite comprenant un renfort en fibres ou fils de carbone consolidé par une matrice organique, c'est-à-dire une résine. Elle s'applique plus particulièrement, mais non exclusivement, à des pièces destinées à participer à la dissipation des calories générées par des sources de chaleur tels que des équipements d'électronique de puissance comme des modules de commande d'actionneurs électrique d'aéronefs, la pièce constituant avantageusement dans ce cas une paroi conductrice ou un boîtier de conditionnement pour l'électronique de puissance.

La fabrication de ces pièces est bien connue et débute par la réalisation d'une structure fibreuse qui peut être sous différentes formes, telles que :
- tissu bidimensionnel (2D),
- tissu tridimensionnel (3D) obtenu par tissage 3D ou multicouches,
- tresse,
- tricot,
- feutre,
- nappe unidirectionnelle (UD) de fils ou câbles ou nappes multidirectionnelle (nD) obtenue par superposition de plusieurs nappes UD dans des directions différentes et liaison des nappes UD entre elles par exemple par couture ou par aiguilletage.

On peut aussi utiliser une structure fibreuse formée de plusieurs couches superposées de tissu, tresse, tricot, feutre, nappes ou autres, lesquelles couches sont liées entre elles par exemple par couture, par implantation de fils ou d'éléments rigides ou par aiguilletage.

Les fils constitutifs de la structure fibreuse sont formés à partir de filaments continus ou discontinus de fibres de carbone.

Après éventuellement une mise en forme, la structure fibreuse est alors consolidée. La consolidation de la structure fibreuse consiste à combler la porosité de la structure, dans tout ou partie du volume de celle-ci, par le matériau constitutif de la matrice.

La matrice du matériau composite est obtenue de façon connue en soi suivant le procédé par voie liquide. Le procédé par voie liquide consiste à imprégner la structure fibreuse par une résine liquide contenant un précurseur du matériau de la matrice. Le précurseur se présente habituellement sous forme d'un polymère éventuellement dilué dans un solvant. La structure fibreuse est placée dans un moule pouvant être fermé de manière étanche avec un logement ayant la forme de la pièce finale moulée. Ensuite, on referme le moule et on injecte la résine dans tout le logement pour imprégner la texture fibreuse selon la technique de moulage par transfert de résine (RTM). D'autres techniques connues d'imprégnation peuvent être utilisées telles que passage de la texture fibreuse dans une imprégnatrice en continu ou imprégnation par infusion.

La pièce en matériau composite peut être également réalisée par drapage (empilement ou superposition) de strates en fils ou fibres de carbone pré-imprégnées avec la matrice. La préforme ainsi constituée est ensuite traitée dans un autoclave pour transformer la résine en matrice solide.

Les autres techniques connues d'élaboration de matériau composite à renfort en fibres de carbone consolidé par une matrice organique font également partie de la présente invention.

La matrice peut être une matrice organique telle qu'une résine thermoplastique ou thermodurcissable. La transformation du précurseur en matrice, à savoir la solidification de la résine, est réalisée par élévation de température dans le cas d'une résine thermodurcissable et par abaissement de température dans le cas d'une résine thermoplastique, généralement par chauffage et/ou refroidissement du moule, après élimination du solvant éventuel, la préforme étant toujours maintenue dans le moule. On forme dans ce cas une pièce en matériau composite à matrice organique (CMO). La matrice organique peut être notamment obtenue à partir de résines époxydes, telle que la résine époxyde à hautes performances.

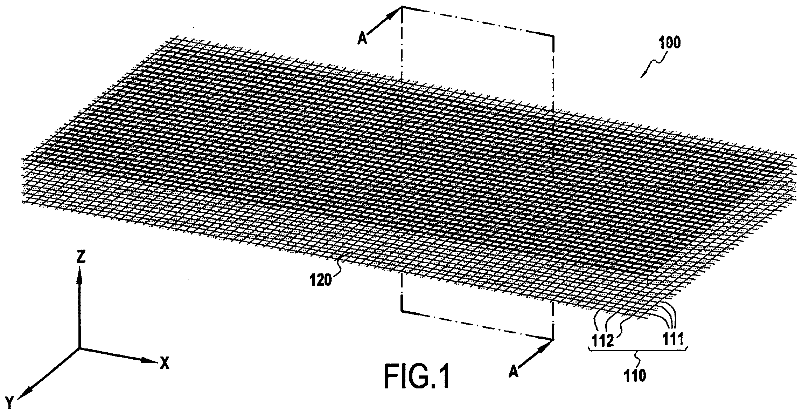

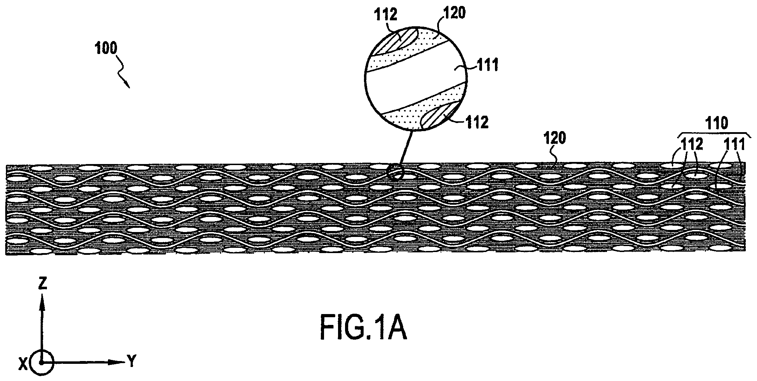

La figure 1 illustre une pièce 100 ici réalisée à partir d'un renfort fibreux 110 obtenu par tissage 3D à armure "interlock" entre une pluralité de fils de chaîne 111 et une pluralité de fils de trames 112, chaque fil étant réalisé à partir de fibres de carbone. Par tissage "interlock", on entend ici une armure de tissage dans laquelle chaque couche de fils de chaîne (ou de trame) lie plusieurs couches de fils de trame (ou de chaîne) avec tous les fils d'une même colonne de chaîne (ou de trame) ayant le même mouvement dans le plan de l'armure. Le renfort fibreux 100 a été ici consolidé avec une matrice organique 120 obtenue par injection RTM d'une résine époxyde dans le renfort fibreux qui a été ensuite polymérisée.

Comme illustré sur la vue de détail agrandie de la figure 1A, les nombreuses porosités du renfort fibreux 110 sont remplies par la matrice 120. Les fils de carbone 111 et 112 sont alors enrobés par la matrice de résine 120 et ne sont plus intimement en contact les uns avec les autres, ce qui diminue fortement la conductivité thermique et électrique dans le matériau composite de la pièce.

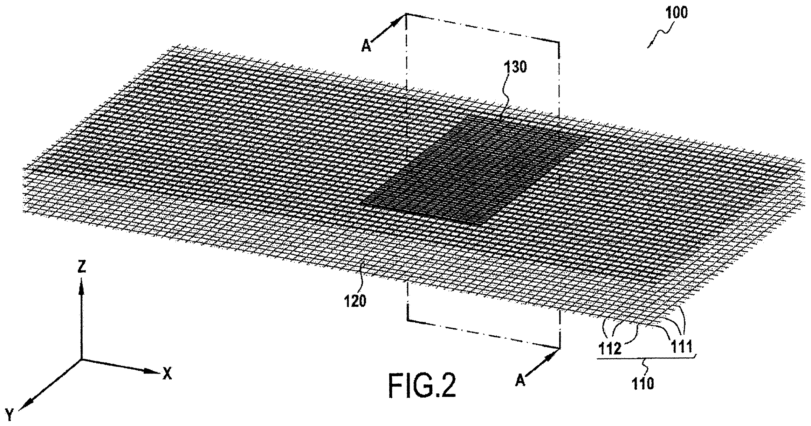

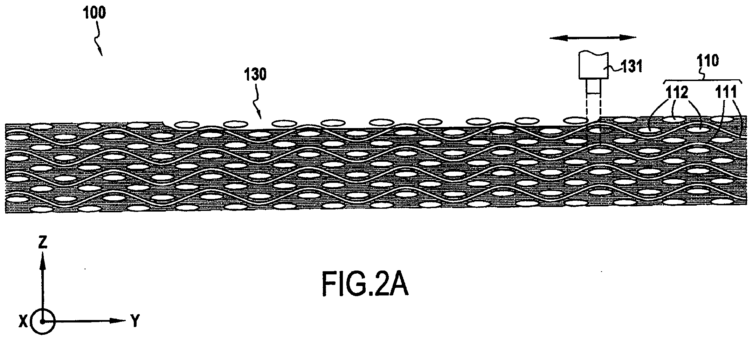

Conformément à l'invention et tel que représenté sur les figures 2 et 2A, on procède à un retrait localisé de matrice en surface du matériau composite de la pièce. Dans l'exemple décrit ici la matrice de résine solide est retirée par jet d'eau sous pression 131 sur une portion déterminée 130 à la surface de la pièce 100. Toute autre technique de retrait ou d'abrasion mécanique, tel que le grenaillage ou le sablage par exemple, permettant d'attaquer la matrice et d'exposer les fils ou fibres présents en surface de la portion attaquée peut être utilisée. La pièce est attaquée sur toute la surface délimitée par la portion 130 avec le jet d'eau sous pression 131 qui permet de mettre à nu les fils de chaîne 111 et les fils de trame 112 présents au niveau de la portion 130 sur une profondeur déterminée s'étendant à partir de la surface supérieure de la pièce 100.

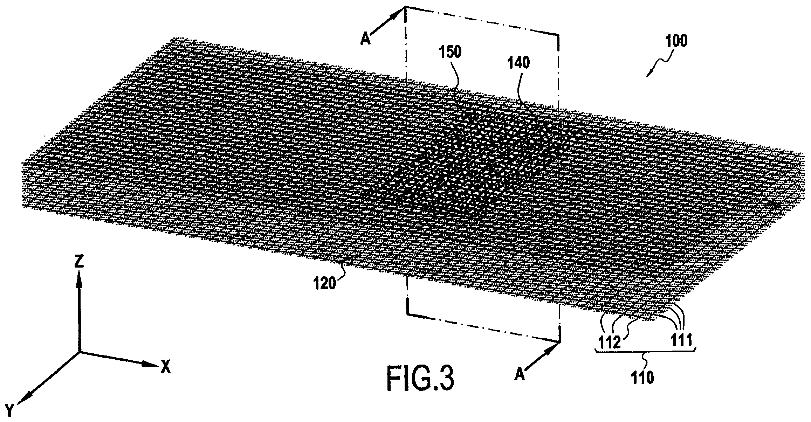

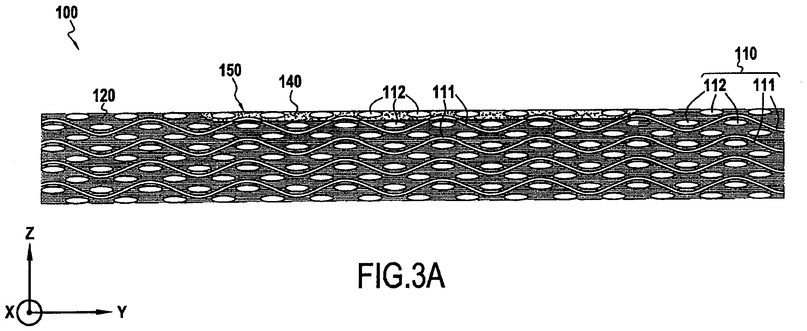

Toujours conformément à l'invention, on procède ensuite au dépôt d'un matériau thermiquement conducteur 140 dans les porosités ré-ouvertes par le retrait de la matrice au niveau de la portion 130 comme illustré que les figures 3 et 3A. Le matériau 140 est de préférence également électriquement conducteur. Le matériau 140 présente de préférence une conductivité thermique supérieure ou égale à 230 W.m⁻¹.K⁻¹ et une conductivité électrique supérieure ou égale à 3,78 10⁷ S.m⁻¹. Le matériau thermiquement et électriquement conducteur 140 peut être notamment un matériau métallique tel qu'un alliage d'aluminium, déposé par plasma, trempage dans un bain de métallisation, application d'une peinture conductrice, etc. La technique de dépôt de la couche de métallisation est choisie en fonction de l'épaisseur de la couche à former qui est généralement comprise entre quelques micromètres et quelques millimètres. Comme illustré sur les figures 3 et 3A, on forme ainsi dans le matériau composite de la pièce 100 une portion de conductivité thermique et électrique 150 dans laquelle des ponts thermiques et des zones de contact électriques sont créés entre les fils de chaîne 111 et les fils de trame 112 grâce au remplacement local de la matrice 120 par le matériau thermiquement et électriquement conducteur 140.

Dans le mode de réalisation qui vient d'être décrit en relation avec la pièce 100, la portion de conductivité thermique et électrique a été formée à la surface de celle-ci. Toutefois, la portion de conductivité thermique et électrique peut être également formée plus en profondeur dans le matériau composite de la pièce comme expliqué ci-après.

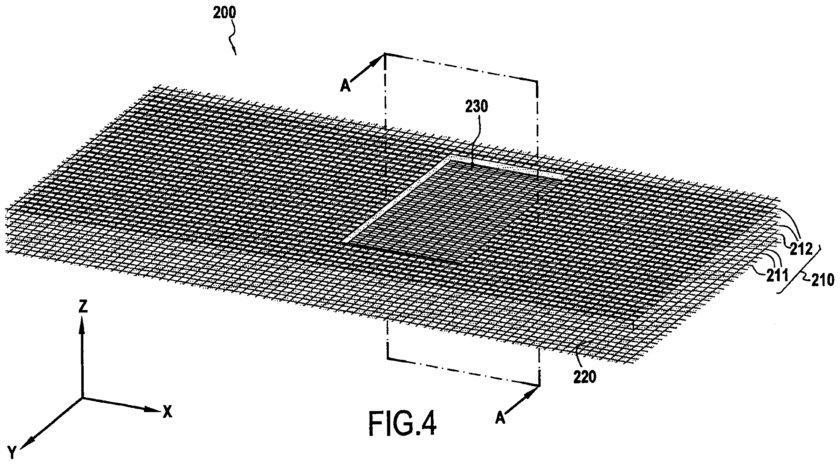

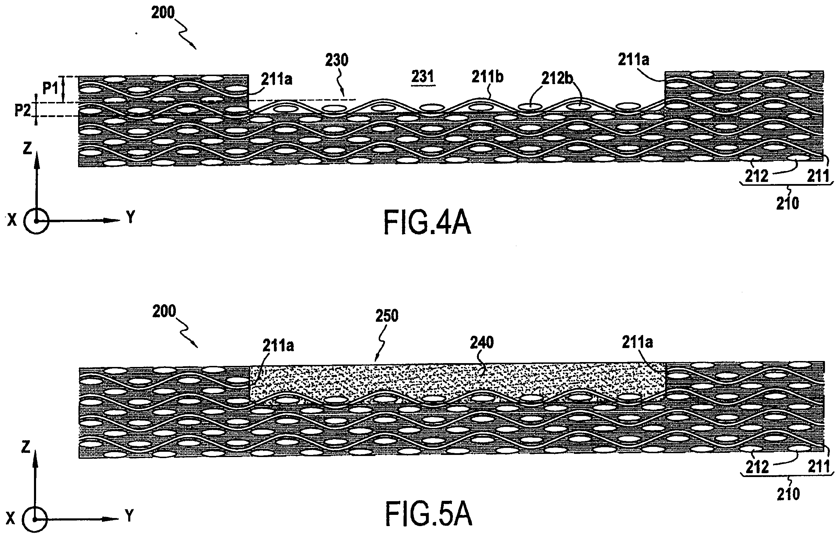

La figure 4 illustre une pièce 200 ici réalisée à partir d'un renfort fibreux 210 obtenu par tissage 3D, par exemple à armure "interlock", entre une pluralité de fils de chaîne 211 et une pluralité de fils de trames 212, chaque fils étant réalisé à partir de fibres de carbone. Le renfort fibreux 200 a été ici consolidé avec une matrice organique 220 obtenue par injection RTM d'une résine époxyde dans le renfort fibreux puis polymérisation de la résine injectée.

Conformément à l'invention et tel que représenté sur les figures 4 et 4A, on procède à une attaque mécanique du matériau composite de la pièce sur une portion déterminée avec une force plus importante que celle utilisée pour mettre à nu les fils en surface de la pièce 100 décrite précédemment. Dans le cas d'une attaque avec un jet d'eau par exemple, on règle la pression de celui-ci de manière à attaquer le matériau de la pièce 200 plus en profondeur que celui de la pièce 100. De cette manière, sur une première profondeur P1 s'étendant à partir de la surface de la pièce 200, on attaque non seulement la résine 220 mais aussi les fils de chaîne 211 et de trames 212 de manière à former un évidement 231 au niveau de la portion 230. Sur une deuxième profondeur P2 s'étendant sous la profondeur P1, seule la résine 220 est attaquée car la force d'impact du jet d'eau est moindre. Les fils de chaîne 211b et de trame 212b présents dans cette zone de profondeur P2 sont alors mis à nu comme illustré sur la figure 4A. Toute autre technique de retrait ou d'abrasion mécanique, tel que le grenaillage ou le sablage par exemple, peut être utilisée.

Toujours conformément à l'invention, on procède ensuite au comblement de la portion 230 par le dépôt d'un matériau thermiquement conducteur 240 à la fois dans les porosités ré-ouvertes des fils mis à nu sur la profondeur P2 et dans la zone découverte sur la profondeur P1 (évidement 231). Le matériau 240 est de préférence également électriquement conducteur et peut être notamment un des matériaux décrits ci-avant.

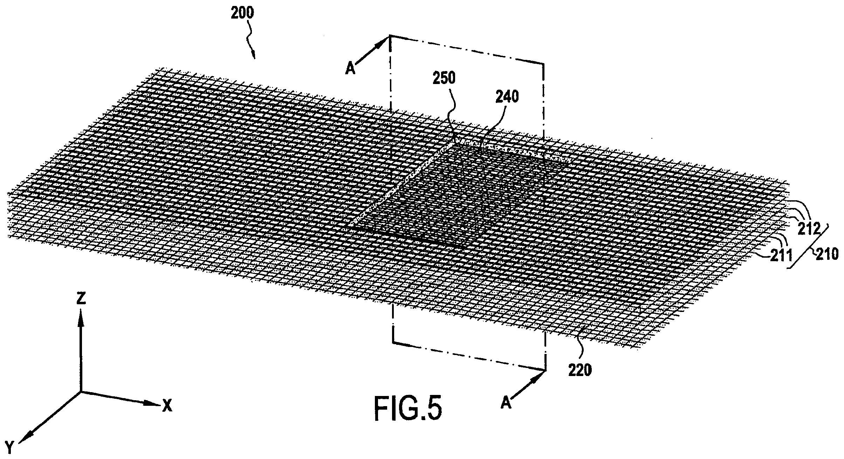

Comme illustré sur les figures 5 et 5A, on forme ainsi dans le matériau composite de la pièce 200 une portion de conductivité thermique et électrique 250 qui est localisée au cœur du matériau composite de la pièce, des ponts thermiques et zones de contact électriques étant créés entre des fils de chaîne 211b et des fils de trame 212b situés à cœur de la pièce. En outre, le matériau thermiquement et électriquement conducteur 240 étant également déposé dans la zone découverte sur la profondeur P1, des ponts thermiques et zones de contact électriques sont également créés au niveau des extrémités des fils de chaîne 211a et de trame (non représentés sur la coupe de la figure 5A) présentes sur les bords de la portion 230 au niveau de cette zone.

On décrit maintenant un autre mode de réalisation de l'invention permettant de former une portion de conductivité thermique et électrique à cœur d'une pièce en matériau composite.

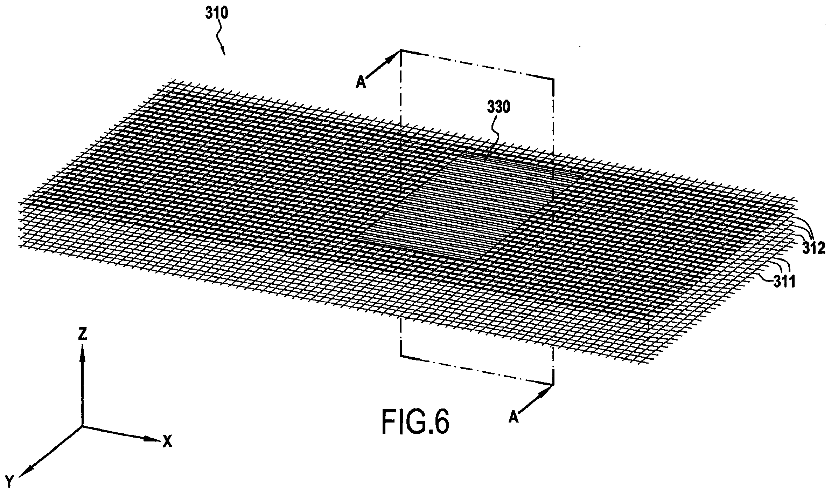

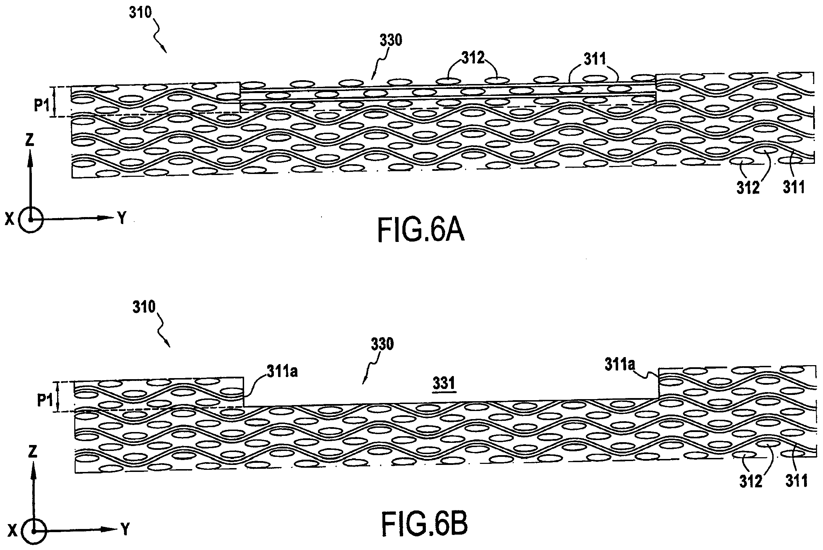

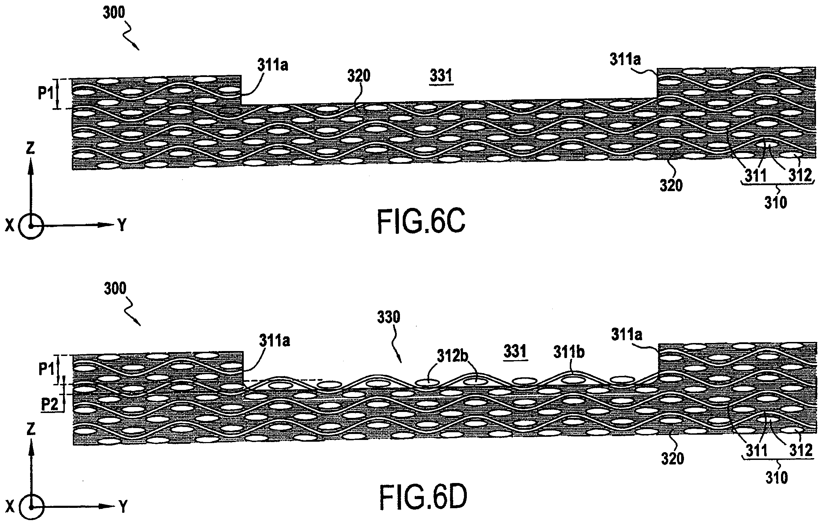

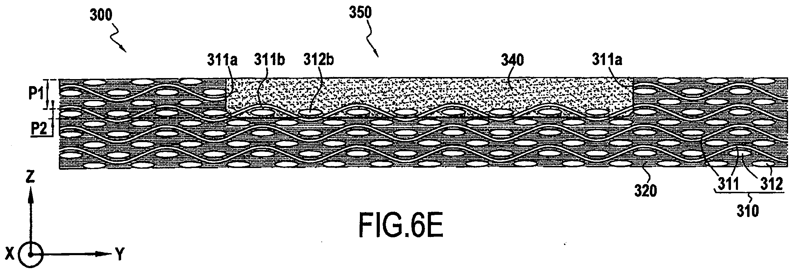

La figure 6 illustre un renfort fibreux 310 obtenu par tissage 3D, par exemple à armure "interlock", entre une pluralité de fils de chaîne 311 et une pluralité de fils de trames 312, chaque fils étant réalisé à partir de fibres de carbone.

Le renfort fibreux 310 comporte une portion 330 qui correspond à une zone de déliaison dans le renfort, c'est-à-dire que les fils de chaîne 311 présents dans la portion 330 sur une première profondeur P1 n'ont pas été tissés avec des fils de trame 312 comme illustré sur la figure 6A.

Après la réalisation du renfort 310, les fils de chaîne 311 non tissés sont découpés, par exemple au laser ou au jet d'eau, de manière à former dans le renfort un évidement 331 s'étendant sur la première profondeur P1 (figure 6B).

Le renfort fibreux 310 est ensuite consolidé avec une matrice organique 320 obtenue par injection RTM d'une résine époxyde dans le renfort fibreux et polymérisation de la résine injectée de manière à former une pièce 300 en matériau composite (figure 6C).

Conformément à l'invention et tel que représenté sur la figure 6D, on procède au retrait par attaque mécanique de la matrice 320 présente sur une deuxième profondeur déterminée P2 de manière à découvrir les fils de chaîne 311b et de trame 312b présents à la surface de l'évidement au niveau de la portion 330 (Figure 6D). Dans l'exemple décrit ici la matrice de résine solide est retirée avec une grenailleuse. Toute autre technique de retrait ou d'abrasion mécanique, tel que le jet d'eau sous pression ou le sablage par exemple, peut être utilisée.

Toujours conformément à l'invention, on procède ensuite au comblement de la portion 330 par le dépôt d'un matériau thermiquement conducteur 340 à la fois dans les porosités ré-ouvertes des fils mis à nu sur la profondeur P2 et dans la zone découverte sur la profondeur P1 (évidement 331) (figure 6E). Le matériau 340 est de préférence également électriquement conducteur et peut être notamment un des matériaux décrits ci-avant.

Comme illustré sur la figure 6E, on forme ainsi dans le matériau composite de la pièce 300 une portion de conductivité thermique et électrique 350 qui peut être localisée au cœur du matériau composite de la pièce. Des ponts thermiques et zones de contact électriques sont donc créés entre des fils de chaîne 311b et des fils de trame 312b. En outre, le matériau thermiquement et électriquement conducteur 340 étant également déposé dans la zone découverte sur la profondeur P1, des ponts thermiques et zones de contact électriques sont également créés au niveau des extrémités des fils de chaîne 311a et de trame (non représentés sur la coupe des figures 6B à 6E) présentes sur les bords de la portion 330 au niveau de cette zone.

La forme, les dimensions et la répartition des portions de conductivité thermique et électrique peuvent être très variées. Elles sont définies en fonction, d'une part, des performances de conduction thermique et/ou électrique désirées et, d'autre part, des propriétés mécaniques minimales que la pièce en matériau composite doit présenter.

Des exemples non limitatifs de forme, dimensions et répartition des portions de conductivité thermique et électrique sont présentés ci-après, les pièces présentant des évidements ou des zones de variations d'épaisseur qui peuvent être notamment réalisés par attaque forte du matériau composite de la pièce ou par formation de zones de déliaison et découpe des fils flottés lors de la réalisation du renfort fibreux comme déjà décrits précédemment.

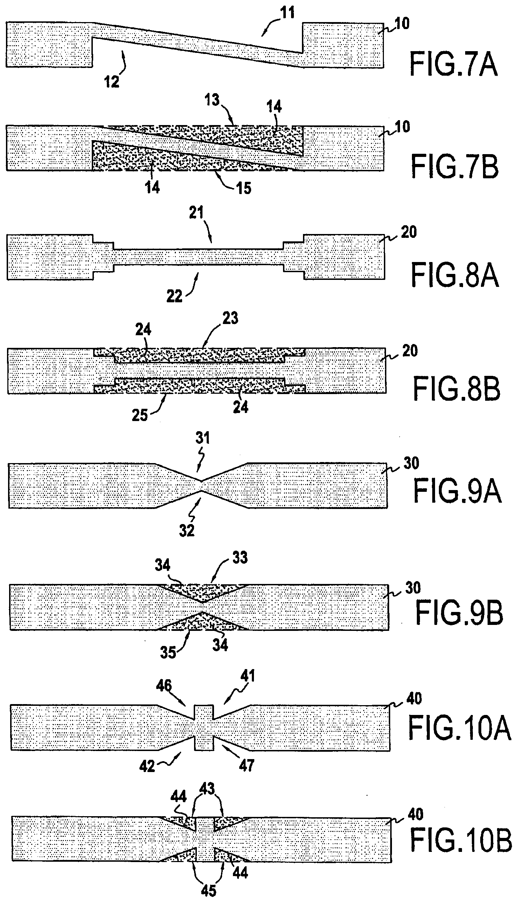

Les figures 7A et 7B montrent une pièce 10 en matériau composite comprenant un renfort en fils de carbone densifié par une matrice de résine comprenant deux évidements ou zones de variation d'épaisseur à profil en pente 11 et 12 réalisés respectivement sur la face supérieure et la face inférieure de la pièce, ces évidements étant, après mise à nu des fils présents en surface de chaque évidement, comblés avec un matériau thermiquement et électriquement conducteur 14 de manière à former des portions de conductivité thermique et électrique 13 et 15.

Les figures 8A et 8B montrent une pièce 20 en matériau composite comprenant un renfort en fils de carbone densifié par une matrice de résine comprenant deux évidements ou zones de variation d'épaisseur à profil en escalier 21 et 22 réalisés respectivement sur la face supérieure et la face inférieure de la pièce, ces évidements étant, après mise à nu des fils présents en surface de chaque évidement, comblés avec un matériau thermiquement et électriquement conducteur 24 de manière à former des portions de conductivité thermique et électrique 23 et 25.

Les figures 9A et 9B montrent une pièce 30 en matériau composite comprenant un renfort en fils de carbone densifié par une matrice de résine comprenant deux évidements ou zones de variation d'épaisseur à profil en V 31 et 32 réalisés respectivement sur la face supérieure et la face inférieure de la pièce, ces évidements étant, après mise à nu des fils présents en surface de chaque évidement, comblés avec un matériau thermiquement et électriquement conducteur 34 de manière à former des portions de conductivité thermique et électrique 33 et 35.

Les figures 10A et 10B montrent une pièce 40 en matériau composite comprenant un renfort en fils de carbone densifié par une matrice de résine comprenant deux évidements ou zones de variation d'épaisseur à profil triangulaire 41 et 46 réalisés sur la face supérieure de la pièce 40 et deux évidements à profil triangulaire 42 et 47 réalisés sur la face inférieure de la pièce, ces évidements étant, après mise à nu des fils présents en surface de chaque évidement, comblés avec un matériau thermiquement et électriquement conducteur 44 de manière à former des portions de conductivité thermique et électrique 43 et 45.

Dans le cas d'un renfort fibreux formés par empilement de strates 2D, l'invention permet de créer des ponts thermiques et des contacts électriques entre les strates du renfort. Dans le cas d'un renfort fibreux obtenu par tissage 3D, l'invention permet de créer des ponts thermiques et des contacts électriques entre les fils du renfort dans les trois directions.

La pièce selon l'invention peut comprendre une ou plusieurs portions de conductivité thermique et électrique. Dans les cas où la pièce comprend plusieurs de ces portions, celle-ci peuvent être alternativement formées en surface et à cœur (dans un évidement) de la pièce afin d'améliorer la conductivité dans la pièce à différentes profondeurs.

La pièce en matériau composite à renfort en fibres ou fils de carbone consolidé par une matrice organique et comprenant une ou plusieurs portions de conductivité thermique conformément à la présente invention peut avantageusement être utilisée pour constituer une ou plusieurs parois conductrices en matériau composite à matrice organique (CMO). La pièce selon l'invention peut également constituer un boîtier destiné à renfermer des circuits ou composants d'électronique de puissance. En effet, la présence d'une ou plusieurs de ces portions permet d'améliorer l'échange de température entre l'intérieur et l'extérieur duboîtier et d'optimiser ainsi le refroidissement de l'électronique de puissance.

## Revendications

1. Pièce en matériau composite (100) comprenant un renfort (110) en fibres ou fils de carbone consolidé par une matrice organique (120), **caractérisée en ce qu'**elle comprend une ou plusieurs portions de conductivité thermique (150) dans lesquelles les fibres ou fils de carbone sont au moins partiellement dépourvus de matrice, **en ce que** les parties des fibres ou fils de carbone dépourvus de matrice sont en contact avec un matériau thermiquement conducteur (140), et **en ce que** le matériau thermiquement conducteur est présent dans les porosités présentes entre les fibres ou fils de carbone dépourvus de matrice.

2. Pièce selon la revendication 1, **caractérisée en ce qu'**elle comporte sur sa surface une ou plusieurs portions de conductivité thermique (150).

3. Pièce selon la revendication 1 ou 2, **caractérisée en ce qu'**elle comprend au moins un évidement (231) et **en ce que** chaque évidement comporte une portion de conductivité thermique (250).

4. Pièce selon l'une quelconque des revendications 1 à 3, **caractérisée en ce que** le matériau thermiquement conducteur (140) est en outre électriquement conducteur.

5. Pièce selon l'une quelconque des revendications 1 à 4, **caractérisée en ce qu'**elle constitue une paroi conductrice en matériau composite à matrice organique.

6. Pièce selon l'une quelconque des revendications 1 à 4, **caractérisée en ce qu'**elle constitue un boîtier pour un équipement d'électronique de puissance.

7. Aéronef comprenant au moins une pièce selon la revendication 5 ou 6.

8. Procédé de réalisation d'une ou plusieurs portions de conductivité thermique dans une pièce en matériau composite (100) comprenant un renfort (110) en fibres ou fils de carbone consolidé par une matrice organique (120), le procédé étant **caractérisé en ce qu'**il comprend les étapes suivantes :
- élimination au moins partielle de la matrice (120) dans une ou plusieurs portions (130) de la pièce de manière à exposer au moins en partie des fibres ou fils de carbone,
- dépôt d'un matériau thermiquement conducteur (140) sur les parties des fibres ou fils exposées.

9. Procédé selon la revendication 8, **caractérisé en ce qu'**il comprend en outre une étape de formation d'au moins un évidement (231) dans la pièce, l'étape d'élimination au moins partielle de la matrice organique (220) étant réalisée dans l'évidement, ledit évidement (231) étant comblé lors de l'étape de dépôt du matériau thermiquement conducteur (240) sur les parties des fibres ou fils exposées.

10. Procédé selon la revendication 9, **caractérisé en ce que** le renfort (310) est réalisé par tissage entre une pluralité de fils de chaîne (311) et une pluralité de fils de trame (312) et **en ce que**, lors la réalisation du renfort, on forme au moins une portion de déliaison (330) s'étendant sur une surface et une profondeur déterminées, les fils flottés présents dans chaque portion de déliaison (330) étant découpés après la réalisation du renfort de manière à former un évidement (331).

11. Procédé selon la revendication 10, **caractérisé en ce que** le matériau thermiquement conducteur (140) est en outre électriquement conducteur.

## Patentansprüche

1. Teil aus Verbundwerkstoff (100), das eine Verstärkung (110) aus Kohlenstofffasern oder -fäden umfasst, welche durch eine organische Matrix (120) verfestigt ist, **dadurch gekennzeichnet, dass** es einen oder mehrere Wärmeleitfähigkeitsabschnitte (150) umfasst, in denen die Kohlenstofffasern oder - fäden wenigstens teilweise keine Matrix aufweisen, und dass die Teile der Kohlenstofffasern oder -fäden, die keine Matrix aufweisen, mit einem wärmeleitenden Material (140) in Kontakt stehen, und dass das wärmeleitende Material in den Poren vorhanden ist, welche zwischen den keine Matrix aufweisenden Kohlenstofffasern oder -fäden vorhanden sind.

2. Teil nach Anspruch 1, **dadurch gekennzeichnet, dass** es auf seiner Oberfläche einen oder mehrere Wärmeleitfähigkeitsabschnitte (150) aufweist.

3. Teil nach Anspruch 1 oder 2, **dadurch gekennzeichnet, dass** es wenigstens eine Aussparung (231) umfasst und dass jede Aussparung einen Wärmeleitfähigkeitsabschnitt (250) umfasst.

4. Teil nach einem der Ansprüche 1 bis 3, **dadurch gekennzeichnet, dass** das wärmeleitende Material (140) ferner elektrisch leitend ist.

5. Teil nach einem der Ansprüche 1 bis 4, **dadurch gekennzeichnet, dass** es eine leitende Wand aus Verbundwerkstoff mit organischer Matrix bildet.

6. Teil nach einem der Ansprüche 1 bis 4, **dadurch gekennzeichnet, dass** es ein Gehäuse für ein Equipment einer Leistungselektronik bildet.

7. Luftfahrzeug, das wenigstens ein Teil nach Anspruch 5 oder 6 umfasst.

8. Verfahren zur Herstellung eines oder mehrerer Wärmeleitfähigkeitsabschnitte in einem Teil aus Verbundwerkstoff (100), das eine Verstärkung (110) aus Kohlenstofffasern oder -fäden umfasst, welche durch eine organische Matrix (120) verfestigt ist, wobei das Verfahren **dadurch gekennzeichnet ist, dass** es die folgenden Schritte umfasst:
- wenigstens teilweises Entfernen der Matrix (120) in einem oder mehreren Abschnitten (130) des Teils, um die Kohlenstofffasern oder -fäden wenigstens teilweise freizulegen,
- Abscheiden eines wärmeleitenden Materials (140) auf den freiliegenden Teilen der Fasern oder Fäden.

9. Verfahren nach Anspruch 8, **dadurch gekennzeichnet, dass** es ferner einen Schritt des Ausbildens wenigstens einer Aussparung (231) in dem Teil umfasst, wobei der Schritt des wenigstens teilweisen Entfernens der organischen Matrix (220) in der Aussparung durchgeführt wird, wobei die Aussparung (231) während des Schritts des Abscheidens des wärmeleitenden Materials (240) auf den freiliegenden Teilen der Fasern oder Fäden aufgefüllt wird.

10. Verfahren nach Anspruch 9, **dadurch gekennzeichnet, dass** die Verstärkung (310) durch Weben zwischen einer Vielzahl von Kettfäden (311) und einer Vielzahl von Schussfäden (312) hergestellt wird und dass während des Herstellens der Verstärkung wenigstens ein Losbindungsabschnitt (330) gebildet wird, der sich über eine bestimmte Fläche und Tiefe erstreckt, wobei die Flottierfäden, die in jedem Losbindungsabschnitt (330) vorhanden sind, nach dem Herstellen der Verstärkung geschnitten werden, um eine Aussparung (331) zu bilden.

11. Verfahren nach Anspruch 10, **dadurch gekennzeichnet, dass** das wärmeleitende Material (140) ferner elektrisch leitend ist.

## Claims

1. A composite material part (100) comprising reinforcement (110) made of carbon fibers or yarns consolidated by an organic matrix (120), the part being **characterized in that** it includes one or more thermally conductive portions (150) in which the carbon fibers or yarns are free of matrix at least in part, and **in that** the matrix-free carbon fiber or yarn portions are in contact with a material (140) that is thermally conductive, and **in that** the material that is thermally conductive is present in the porosities present between the carbon fibers or yarns free of matrix.

2. A part according to claim 1, **characterized in that** it includes one or more thermally conductive portions (150) in its surface.

3. A part according to claim 1 or claim 2, **characterized in that** it includes at least one recess (231) and **in that** each recess includes a thermally conductive portion (250) .

4. A part according to any one of claims 1 to 3, **characterized in that** the thermally conductive material (140) is also electrically conductive.

5. A part according to any one of claims 1 to 4, **characterized in that** it constitutes a conductive wall made of organic matrix composite material.

6. A part according to any one of claims 1 to 4, **characterized in that** it constitutes a package for electronic power equipment.

7. An aircraft including at least one part according to claim 5 or claim 6.

8. A method of making one or more thermally conductive portions in a part (100) made of composite material comprising reinforcement (110) of carbon fibers or yarns consolidated by an organic matrix (120), the method being **characterized in that** it comprises the following steps:
. eliminating at least part of the matrix (120) in one or more portions (130) of the part so as to expose carbon fibers or yarns at least in part; and
. depositing a thermally conductive material (140) on the exposed fiber or yarn portions.

9. A method according to claim 8, **characterized in that** it further comprises a step of forming at least one recess (231) in the part, the step of at least partially eliminating the organic matrix (220) being performed in the recess, said recess (231) being filled in during the step of depositing the thermally conductive material (240) on the exposed fiber or yarn portions.

10. A method according to claim 9, **characterized in that** the reinforcement (310) is made by weaving together a plurality of warp yarns (311) and a plurality of weft yarns (312), and **in that**, while making the reinforcement, at least one portion (330) of non-interlinking is formed that extends over a determined area and depth, the floating yarns present in each portion (330) of non-interlinking being cut away after the reinforcement has been made so as to form a recess (331).

11. A method according to claim 10, **characterized in that** the thermally conductive material (140) is also electrically conductive.
